# EUROPÄISCHE PATENTSCHRIFT

(11) **EP 0 600 850 B1**
(45) Veröffentlichungstag und Bekanntmachung des Hinweises auf die Patenterteilung: **29.05.2002**
(21) Anmeldenummer: 94101691.7
(22) Anmeldetag: 14.02.1991
(51) Int. Cl.: H01L 27/108, H01L 23/522

(54) **DRAM-Zellenstruktur mit Kondensator über Bitleitung und Verfahren zu deren Herstellung**
DRAM cell structure with capacitor over bit line and method of making the same
Structure de cellule DRAM avec condensateur sur la ligne de bit et procédé de sa manufacture

(30) Priorität: 23.02.1990 DD 33809790
(43) Veröffentlichungstag der Anmeldung: 08.06.1994
(62) Teilanmeldung aus: 91102082.4
(73) Patentinhaber: Infineon Technologies AG, 81669 München (DE)
(72) Erfinder: Temmler, Dietmar, Dr., D-15232 Frankfurt (Oder) (DE)
(74) Vertreter: Heitsch, Wolfgang

(56) Entgegenhaltungen:
- DE-A- 3 910 033
- US-A- 4 872 050
- PATENT ABSTRACTS OF JAPAN vol. 14, no. 99 (E-893)(4042) 22. Februar 1990 & JP-A-01 302 852 (FUJITSU LTD) 6. Dezember 1989
- PATENT ABSTRACTS OF JAPAN vol. 14, no. 99 (E-893)(4042) 22. Februar 1990 & JP-A-01 302 851 (FUJITSU LTD) 6. Dezember 1989
- PATENT ABSTRACTS OF JAPAN vol. 14, no. 105 (E-895)(4048) 26. Februar 1990 & JP-A-01 308 069 (FUJITSU LTD) 12. Dezember 1989
- PATENT ABSTRACTS OF JAPAN vol. 12, no. 498 (E-698)(3345) 26. Dezember 1988 & JP-A-63 209 157 (NEC CORP) 30. August 1988

## Beschreibung

Die Erfindung betrifft eine Ein-Transistor-Speicherzellenanordnung für höchstintegrierte dynamische Halbleiterspeicherbausteine nach dem stacked-capacitor-Prinzip (STC) und ein Verfahren zu deren Herstellung.

Aus der DE 39 10 033 ist eine Speicherzelle bekannt, deren Source- bzw. Drainbereich mit einer Bitleitung verbunden ist. Die oberhalb der Bitleitung liegende Kondensatorelektrode ist durch eine mittig angeordnete, isolierte Öffnung in der Bitleitung mit dem Drain- bzw. Sourcebereich des Transistors verbunden. Diese Art der Isolation vermindert den Querschnitt der Bitleitung an der Öffnungsstelle, so daß die Bitleitung ungünstige elektrische Eigenschaften aufweist. Die JP 13 02 852 beschreibt ebenfalls eine Struktur einer Speicherzelle eines Halbleiterspeichers. Auch hier umschließt die Bitleitung beidseitig einen Isolationsmantel, der die elektrische Verbindung zwischen Transistor und Kondensator elektrisch von der Bitleitung trennt. Eine ähnliche Anordnung eines Halbleiterspeichers ist in der JP 63 20 91 57 beschrieben. In allen diesen Schriften wird der Nachteil einer Bitleitung mit verringertem Querschnitt deutlich. Durch Einhaltung eines Mindestquerschnitts der Bitleitung stößt die angestrebte Miniaturisierung schnell an seine Grenzen.

Zur Erreichung hoher Signalpegel bei zugleich geringem Rauschen, hoher Alphateilchen-Immunität und immer packungsdichterer Speicherbausteine wird die Speicherzellenkonstruktion nach dem Prinzip der Ein-Transistor-Zelle /s.u.a. Koyanagi, IEDM Tech. Dig. 1978, 348-351/ grundsätzlich auf die Maximierung der Speicherkapazität im Vergleich zur Bitleitungskapazität und anderen parasitären Koppelkapazitäten ausgerichtet.

Das wird erreicht
- durch die Verwendung von Speicherdielektrika-Schichtmaterial mit großen ε_{R}/d-Werten (ε_{R}, d: relative Dielektrizitätskonstante, Dicke des Speicherisolators) /s.u.a.: J. Carrano, IEDM Tech. Dig.,1989, 255-258/
- durch Herstellung einer möglichst großen aktiven Fläche der Speicherkapazität.

Lösungen für die Realisierung einer großen aktiven Speicherkapazitätsfläche sind
- die Ausbildung tiefer loch- bzw. grabenförmiger Trenchkapazitäten /s. u. a.: T. Furuyama, IEEE Journal of Solid State Circuits, SC 21, No. 5, Okt. 1986, 605-611; A.H. Shah, IEEE Journal of Solid State Circuits, SC 21, No.5, Okt. 1986, 618-626; N. Lu, IEEE Journal of Solid State Circuits, SC 21, No. 5, Okt. 1986, 627-634/
oder
- die Ausbildung dreidimensionaler (3D) STC-Anordnungen
- vom fin-Typ /s.u.a.: T. Kisu, Ext. Abstracts on the 20th Conf. on Solid State Devices and Material, 1988, 581-584; T.Ema, IEDM Tech. Dig. 1988, 592-595; EP-PS 0295709/
- vom cylindrical - Typ /s. u. a.: W. Wakamiya, Symp. on VLSI Technology 1989. 69-70/
- vom rugged-poly-Typ /s.u.a.: T.Mine, Ext. Abstracts on the 2th Conf. on Solid State Devices and Materials 1989, 137-140/.

Unabhängig vom Typ der STC-Konstruktion wird für die Erreichung einer maximalen aktiven Speicherkapazitätsfläche versucht, die STC-Layoutfläche, soweit möglich, auf die Gesamtfläche des Speicherzellenlayouts auszudehnen, ohne daß konstruktive Nachteile für die Bitleitungsverdrahtung entstehen.

Bitline-on-capacitor-Anordnungen (BOC: STC-Anordnung zwischen Wort- und Bitleitungsebene) weisen diesbezüglich Nachteile auf /s. u. a.: EP - PS 019 1612; Ema, IEDM Tech. Dig. 1988, 592-595; W.Wakamiya, Symp. on VLSI Technology 1989, 69-70; EP-PS 0263941/
- die Layoutfläche der Speicherzelle kann durch den STC-Komplex prinzipiell nur bis auf den Bereich des Bitleitungskontaktfensters belegt werden
- durch die STC-Vertikalausdehnung wird eine große Tiefe des Bitleitungskontaktfensters verursacht, damit werden u.a. aufwendige Maßnahmen zur Sicherung eines zuverlässigen, niederohmigen Bitleitungskontaktes und einer in diesem Bereich abrißfreien Bitleitung notwendig.

Deshalb werden für dynamische Speicherzellenbausteine ab 16...64 MdRAM zunehmend Ein-Transistorzellen mit Capacitor-on-bitline-Struktur (COB: STC-Anordnung oberhalb der Bitleitungsebene) eingesetzt. Diese haben den Vorteil, daß prinzipiell die gesamte Layoutfläche der Speicherzelle von der STC-Konstruktion belegt werden kann und daß die Bitleitungsführung bezüglich des Source-Kontaktes problemlos und zuverlässig möglich ist. Nachteilig gegenüber der BOC-Anordnung ist, daß die Bitleitung am Drainkontaktfenster, das dem STC-Drainanschluß dient, seitlich isoliert vorbeigeführt werden muß, wobei zwischen Bitleitung und Drainkontaktfenster ein justagebedingter Sicherheitsabstand einzuhalten ist, der zusätzliche Speicherzellenfläche oder einen nachteiligen "diagonalen" MOS-Auswahltransistor und einen ausbeutemindernden kritischen Justageprozeß zwischen Drainkontaktfenster- und Bitleitungsebene erfordert /s.u.a.: Ema, IEDM Tech. Dig., 1988, 592-595; S. Kimura IEDM Tech. Dig., 1988, 596-599; S.Inoue, IEDM Tech. Dig., 1989, 31-34/.

Ziel der Erfindung ist eine STC-Ein-Transistor-Speicherzellenanordnung für höchstintegrierte dynamische Halbleiterspeicherbausteine größer/gleich 16 MdRAM und ein Verfahren zu deren Herstellung, die unabhängig von der konkreten Konstruktion der i.a. dreidimensionalen STC-Speicherkapazität die Leistungsparameter, Packungsdichte und Ausbeute der Speicherbausteine wesentlich verbessert.

Der Erfindung liegt die Aufgabe zugrunde, den bei STC-Speicherzellen mit oberhalb der Bitleitungsebene angeordnetem STC-Speicherkapazitätskomplex (COB-Struktur) entsprechend dem Stand der Technik bisher notwendigen justagebedingten Sicherheitsabstand zwischen Bitleitung und Drainkontaktfenster, über das der Anschluß der STC-Speicherelektrode an den MOS-Auswahltransistor erfolgt, zu eliminieren, unabhängig von der konkreten Konstruktion der i.a. dreidimensional gestalteten STC-Speicherkapazität.

Dadurch soll
- die Speicherzellenlayoutfläche verringert,
- die hinsichtlich Leistungsfähigkeit des Auswahltransistors vorteilhafte geradlinige und
   in der Draufsicht rechtwinklig sich kreuzende Wort- und Bitleitungsführung realisierbar und
- der Justageprozeß der Drainkontaktfensterebene zur Bitleitungsebene toleranzunempfindlich gestaltet werden,
so daß packungsdichtere, leistungsfähigere Speicherbausteine mit höherer technologischer Sicherheit und Ausbeute hergestellt werden können.

Erfindungsgemäß wird die Aufgabe dadurch gelöst, daß ein isolierter, leitender Stempel, der das Draingebiet kontaktiert, die Isolationsschichten unter- und oberhalb der Bitleitung und die Bitleitung selbst durchstößt und in die Unterseite der STC-Speicherelektrode übergeht, als leitende Verbindung zwischen Drain des MOS-Auswahltransistors und STC-Speicherelektrode beliebiger Konstruktion angeordnet ist, wobei dieser Stempel an seinem Umfang von einem Isolationsmantel mit konstanter Dicke bedeckt ist, der die laterale Isolation zur angeschnittenen, ein- oder beidseitig um den Stempel herumführende Bitleitung sicherstellt, der Isolationsmantel mit konstanter Dicke zentriert zum Stempel angeordnet ist, die durch den Stempel und dessen Isolationsmantel angeschnittene Bitleitung einseitig um den Stempel herumgeführt ist oder bei beidseitiger Herumführung der Bitleitung oder bei Vollständiger Durchtrennung der Bitleitung durch den Stempel an der Bitleitung in jedem Fall ein leitfähiger Ring zur Sicherstellung des elektrisch erforderlichen Mindestquerschnitts der Bitleitung im unmittelbaren Bereich des Stempels angeordnet ist und die Höbe des leitfähigen Ringes größer ist als die Höbe der Bitleitung außerhalb des Bereich des Stempels.

Erfindungsgemäß wird die Aufgabe der Erfindung weiterhin durch ein von der konkreten Konstruktion der i.a. dreidimensional gestalteten STC-Speicherkapazität unabhängiges Verfahren zur Herstellung einer STC-Ein-Transistor-Speicherzellenanordnung gelöst, indem nach Herstellung der Wortleitung und der Source- und Draingebiete des MOS-Auswahltransistors eine untere Isolationsschicht ausgebildet wird, daß danach das Sourcekontaktfenster strukturiert wird, daß anschließend die Bitleitung ausgebildet wird, wobei zugleich der Sourcekontakt hergestellt wird, daß im Anschluß daran eine die Bitleitung bedeckende obere Isolationsschicht ausgebildet wird, daß danach durch einen anisotropen Ätzprozeß über eine Lackmaske ein Drainkontaktfenster durch die obere Isolationsschicht, durch die Bitleitung und durch die untere Isolationsschicht geätzt wird, die Bitleitung dabei einseitig angeschnitten, beidseitig um den Stempel herumgeführt oder vollständig durchtrennt wird, der Ätzprozeß vor Erreichen der Drainoberfläche des Substrates gestoppt wird, so daß die innerhalb des Drainkontaktfensters liegenden Teile der Feld- und Wortleitungsisolation nicht beschädigt werden, bei beidseitig um den Stempel herumgeführter Bitleitung diese durch einen leitfähigen Ring verstärkt wird, daß anschließend eine weitere Isolationsschicht isotrop abgeschieden wird, wobei die Dicke dieser Schicht deutlich kleiner als die halbe Drainkontaktfensterbreite ist, daß im Anschluß daran mittels eines anisotropen RIE-Prozesses das durch die Schicht verengte Drainkontaktfenster bis auf die Drainoberfläche des Substrates vertieft wird, wodurch eine rundum isolierende, selbstjustierende Bedeckung der Drainkontaktfensterflanken incl. der entlang der Durchstoßlinie des Drainkontaktfensters freiliegenden Flanken der Bitleitung in Form eines Isolationsmantels erzeugt wird und daß anschließend der STC-Komplex, beginnend mit der Ausbildung der untersten leitenden Schicht der STC-Speicherelektrode, ausgebildet wird, wobei die Dicke der untersten leitenden Schicht größer ist, als die durch den Isolationsmantel verminderte halbe Breite des Drainkontaktfensters, so daß dieses vollständig mit einem leitenden Stempel ausgefüllt wird, der in seinem oberen Abschnitt in die STC-Speicherelektrode übergeht.

In einer weitergehenden Ausgestaltung der STC-Speicherzellenanordnung und des Verfahrens zu deren Herstellung wird die im Drainkontaktfensterbereich im Querschnitt geschwächte Bitleitung vor Ausbildung des Isolationsmantels durch einen leitfähigen Ring verstärkt, indem bei dem anisotropen RIE-Prozeß zur Ätzung des Drainkontaktfensters, der die Bitleitung im Drainbereich in ihrer Breite völlig oder teilweise durchtrennt, die untere Isolationsschicht zunächst nur teilweise angeätzt wird, danach eine leitende Schicht isotrop abgeschieden wird, wobei deren Dicke deutlich kleiner als die halbe Drainkontaktfensterbreite ist, im Anschluß daran ein anisotroper RIE-Prozeß durchgeführt wird, der die leitende Schicht nur auf der oberen Isolationsschicht und auf dem Boden des Drainkontaktfensters entfernt, an den Flanken des Drainkontaktfensters jedoch einen leitenden Ring beläßt, der die bei der Drainkontaktfensterstrukturierung an den Drainkontaktfensterflanken entstehenden freien Bitleitungsflanken mit seinem äußeren Umfang kontaktiert, nachfolgend eine dünne Isolationsschicht mit einer Dicke, die deutlich kleiner ist, als die durch den leitenden Ring verringerte Breite des Drainkontaktfensters, isotrop abgeschieden wird bzw. das Bitleitungsringmaterial zur Ausbildung der Isolationsschicht oxidiert oder nitriert wird, wobei dieser Schichtausbildung eine weitere Schichtabscheidung zur Ausbildung der kompletten Isolationsschicht folgen kann.

Anschließend wird die dünne Isolationsschicht mit einem anisotropen RIE-Prozeß auf allen horizontalen Flächen abgeätzt, während sie an der inneren senkrechten Wandfläche des leitenden Ringes und des Drainkontaktfensters verbleibt, danach wird der leitende Ring selektiv zur umgebenden Isolation bis auf ein Niveau oberhalb der Bitleitungsoberfläche abgeätzt, wobei die dünne Isolationsschicht, welche die innere Wandfläche des Ringes bedeckt, als Bestandteil des Isolationsmantels vollständig erhalten bleibt, anschließend wird eine weitere Isolationsschicht mit einer Schichtdicke größer als die halbe Wandstärke des Ringes isotrop abgeschieden, im Anschluß daran wird das Drainkontaktfenster bis auf die Substratoberfläche anisotrop mit einem RIE-Prozeß vollständig geöffnet, wodurch zugleich der Isolationsmantel komplettiert wird, und danach wird der STC-Komplex, beginnend mit der Abscheidung der untersten Schicht der STC-Speicherelektrode, ausgebildet, wobei die Dicke dieser untersten Schicht größer ist als die nach Ausbildung des Isolationsmantels verbleibende halbe Breite des Drainkontaktfensters, so daß dieses vollständig mit einem leitenden Stempel ausgefüllt wird, der in seinem oberen Abschnitt in die STC-Speicherelektrode übergeht.

Die Erfindung soll nachstehend anhand eines Ausführungsbeispieles näher erläutert werden. In den zugehörigen Zeichnungen zeigen
Fig. 1a: Zellenkonstruktionsschema einer STC-COB-Speicherzellenanordnung mit im Drainbereich seitlich angeschnittener Bitleitung, deren verbleibender Querschnitt ohne Verstärkung ausreichend ist und die vom leitenden Stempel der STC-Speicherelektrode durch einen Isolationsmantel selbstjustierend getrennt ist (STC-Speicherelektrode abgetrennt dagestellt), hilfreich zum Verständnis der Erfindung.
Fig. 1c. Querschnitt einer STC-COB-Speicherzellenanordnung mit seitlich angeschnittener Bitleitung, entsprechend Fig. 1a
Fig. 2a-d: Stadien der Herstellung eines STC-COB-dRAM-Speichers mit seitlich angeschnittener Bitleitung im Querschnitt, ab Öffnung des Drainkontaktfensters (Fig.2a) bis zur kompletten Speicherzelle (Fig.2d), hilfreich zum Verständnis der Erfundung.
Fig. 3a: Zellenkonstruktionsschema einer STC-COB-Speicherzellenanordnung mit im Drainbereich vollständig durchtrennter Bitleitung, deren Stromtransport in diesem Abschnitt durch einen leitfähigen Bitleitungsring übernommen wird, der selbstjustierend zum leitenden Stempel der STC-Speicherelektrode angeordnet ist und von diesem durch einen selbstjustierten Isolationsmantel getrennt ist (STC-Speicherelektrode abgetrennt dargestellt)
Fig. 3c: Querschnitt einer STC-COB-Speicherzellenanordnung mit einem im Drainbereich selbstjustierend angeordneten, vom leitenden Stempel der STC-Speicherelektrode mittels selbstjustiertem Isolationsmantel getrennten leitfähigen Bitleitungsring, der den Stromtransport der Bitleitung sichert, entsprechend Fig.3a,3b
Fig. 4a-f: Stadien der Herstellung eines STC-COB-dRAM-Speichers mit selbstjustierter Bitleitungsringkonstruktion imQuerschnitt, ab Öffnung des Drainkontaktfensters (Fig.4a) bis zur kompletten Speicherzelle (Fig.4f)

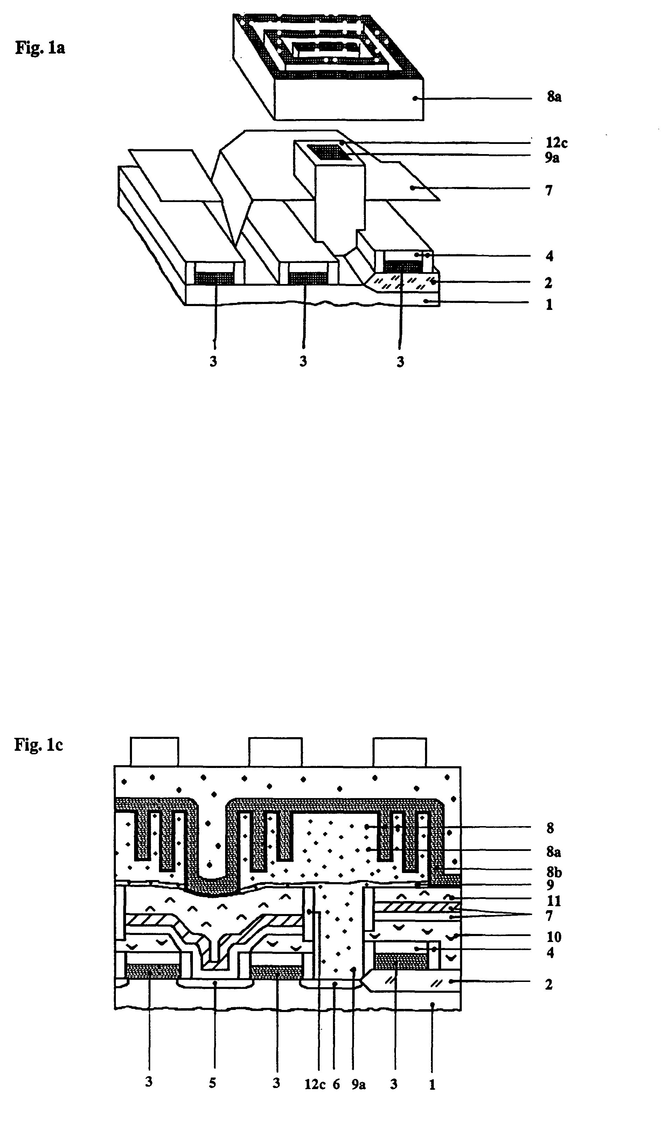

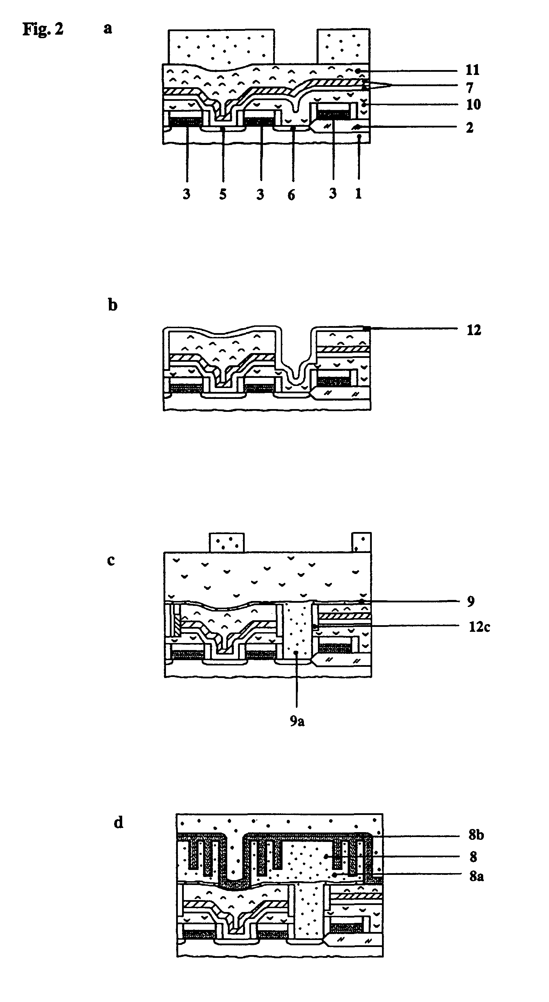

Eine für das Verständnis der Erfindung wichtige Ausführungsform STC-COB-Speicherzellenanordnung auf Siliciumsubstrat mit im Drainbereich seitlich angeschnittener Bitleitung, ohne zusätzliche Verstärkung und Verfahren zu deren Herstellung (Fig. 1, Fig. 2).
Nach Herstellung der Feldisolation **2** und der aktiven Gebiete, der LDD-MOS-Transistoren **3** mit Source- **5** und Draingebiet **6** und der Polysilicium-Wortleitungen **3** mit lateraler und vertikaler Wortleitungsisolation 4 wird eine 400 nm dicke, verrundete untere Isolationsschicht **10** aufgebracht und strukturiert, wodurch in der Speichermatrix Sourcekontaktfenster geöffnet werden. Nachfolgend wird durch Abscheidung, Dotierung und Strukturierung einer Polycid-Schicht die Bitleitung **7** erzeugt und angeschlossen, wobei dic Bitleitungsführung im Drainbereich **6** geringfügig asymmetrisch erfolgt, so daß die spätere Drainkontaktfensteröffnung nur einen Teil des Bitleitungsquerschnitts entfernt. Danach wird eine 650 nm dicke, mittels RTA verrundete obere Isolationsschicht **11** aufgebracht und mit einem RIE-Prozeß über eine Lackmaske in den Draingebieten **6** der n-LDD-MOS-Transistoren der Speichermatrix steilflankig Drainkontaktfenster in die obere Isolationsschicht **11** eingebracht, wobei der Ätzprozeß selektiv auf der Bitleitungsoberfläche stoppt.
Mit einem weiteren RIE-Prozeß wird der im Drainkontaktfenster freigelegte Teil der Bitleitung **7** durchtrennt, danach die untere Isolationsschicht **10** bis auf eine verbleibende Restdicke von 200 nm angeätzt.
Nach Entfernung der Lackmaske wird eine 180 nm dicke Isolationsmantelschicht **12** mittels LPCVD-Verfahren isotrop abgeschieden und anschließend durch einen anisotropen RIE-Prozeß auf allen horizontalen Flächen wieder entfernt, so daß nur die Drainkontaktfensterflanken einschließlich der angeschnittenen freiliegenden Bitleitungsflanken von einem Isolationsmantel **12c** konform und selbstjustierend bedeckt werden. Durch Fortsetzung des RIE-Prozesses wird nachfolgend die im eingeengten Drainkontaktfenster verbliebene Restdicke der unteren Isolationsschicht **10** bis zur Freilegung der Siliciumsubstratoberfläche **1** entfernt.
Danach wird eine n⁺-leitende Polysiliciumschicht mit einer Dicke größer als der Radius des durch die Isolationsmantelschicht **12** verengten Drainkontaktfensters als unterste leitende Schicht **9** der STC-Speicherelektrode **8a** abgeschieden. Diese Schicht **9** füllt das verbleibende Drainkontaktfenster in Form eines leitenden Stempels **9a**, der den Kontakt zum Drain **6** des MOS-Auswahltransistors **3** herstellt und in seinem oberen Abschnitt in die STC-Speicherelektrode **8a** übergeht, vollständig aus.
Die notwendige laterale Isolation zwischen dem leitenden Stempel **9a** und der durch den steilflankigen Drainkontaktfenster-Ätzprozeß seitlich angeschnittenen Bitleitung **7** wird durch den Isolationsmantel **12c**, der den leitenden Stempel **9a** selbstjustierend umhüllt, sichergestellt.

Danach wird der STC-COB-Speicherchip, beginnend mit der Komplettierung des 3D-STC-Komplexes **8**, fertiggestellt.

### Ausführungsbeispiel 1:

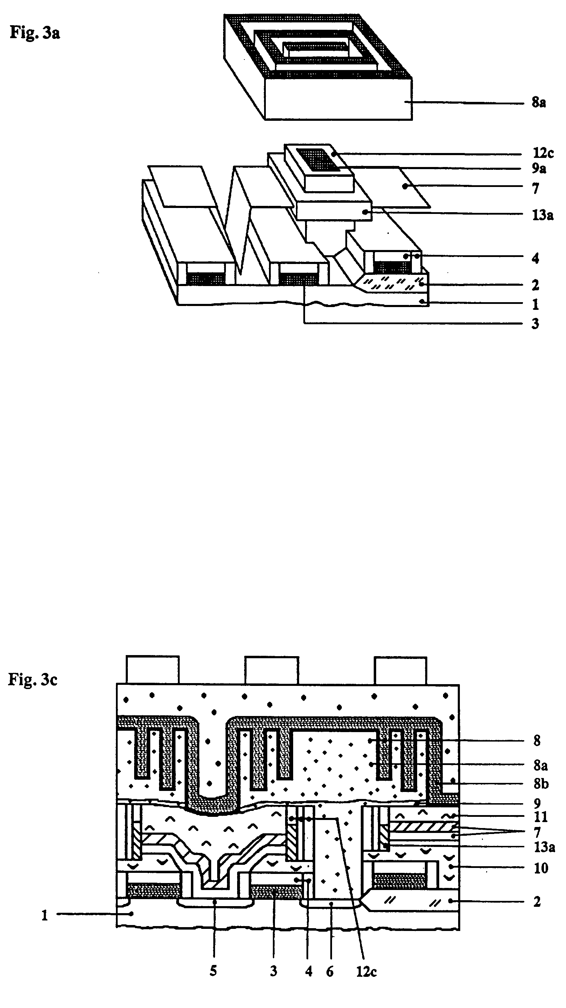

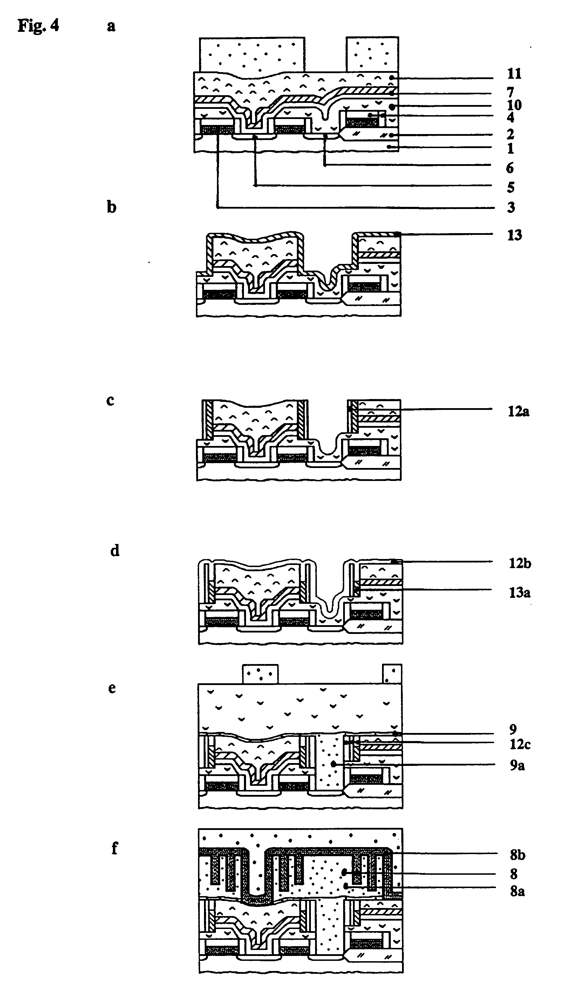

STC-COB-Speicherzellenanordnung auf Siliciumsubstrat mit im Drainbereich vollständig durchtrenntem, durch einen leitfähigen Ring fünktionell ersetztem Bitleitungsabschnitt und Verfahren zu deren Herstellung (Fig. 3, Fig.4).
Nach Herstellung der Feldisolation **2** und der aktiven Gebiete, der LDD-MOS-Transistoren **3** mit Source- **5** und Draingebiet **6** und der Polysilicium-Wortleitungen **3** mit lateraler und vertikaler Wortleitungsisolation 4 wird eine 400 nm dicke, verrundete untere Isolationsschicht **10** aufgebracht und strukturiert, wodurch in der Speichermatrix Sourcekontaktfenster geöffnet werden. Nachfolgend wird durch Abscheidung, Dotierung und Strukturierung einer Polycid-Schicht die Bitleitung **7** erzeugt und angeschlossen, wobei die Bitleitungsführung im Drainbereich **6** geradlinig und symmetrisch zur Mittelachse des Speicherzellenlayouts erfolgt.
Danach wird eine 650 nm dicke, mittels RTA verrundete, obere Isolationsschicht **11** aufgebracht und mit einem RIE-Prozeß über eine Lackmaske in den Draingebieten **6** der n-LDD-MOS-Transistoren der Speichermatrix steilflankig Drainkontaktfenster in die obere Isolationsschicht **11** eingebracht, wobei der Ätzprozeß selektiv auf der Bitleitungsoberfläche stoppt.
Mit einem weiteren RIE-Prozeß wird der im Drainkontaktfenster freigelegte Teil der Bitleitung **7** durchtrennt, danach die untere Isolationsschicht **10** bis auf eine verbleibende Restdicke von 200 nm angeätzt.
Nach Entfernung der Lackmaske wird eine 20 nm dicke, phosphordotierte Polysiliciumschicht abgeschieden.
Danach wird eine die Steilflanken des Drainkontaktfensters konform bedeckende, 200 nm dicke Wolfram-CVD-Schicht aufgebracht und durch einen folgenden anisotropen RIE-Prozeß von allen horizontalen Flächen wieder entfernt. An den Steilflanken des Drainkontaktfensters bleibt die aus Wolfram und Polysilicium bestehende Doppelschicht **13** jedoch in Form eines leitenden Ringes **13a** bestehen. Der leitende Ring **13a** kontaktiert die durch den Drainkontaktfenster-Ätzprozeß durchbrochene Bitleitung **7** selbstjustierend und schließt sie bis auf das im Zentrum des leitenden Ringes **13a** verbleibende Drainkontaktfenster wieder vollständig.
Bei diesem RIE-Ätzprozeß erfolgt ein großflächiger Abtrag der oberen Isolationsschicht **11** und im Bereich des verbliebenen Drainkontaktfensters zugleich der unteren Isolationsschicht **10** von ca. 50 nm.
Im Anschluß an diesen Ätzprozeß wird eine dünne Isolationsmantelschicht **12a** in Form einer 50 nm dicken Siliciumnitridschicht mittels LPCVD-Verfahren abgeschieden und durch einen anisotropen RIE-Ätzprozeß von den horizontalen Flächen wieder entfernt, dabei bleibt die Siliciumnitridschicht **12a** an der inneren vertikalen Wandfläche des leitenden Ringes **13a** mit ungeschwächter Dicke erhalten.
Anschließend wird die freiliegende obere Deckfläche des leitenden Ringes **13a** selektiv bis auf ein Niveau von ca. 100 nm oberhalb der Bitleitungsoberfläche abgeätzt, wobei die Siliciumnitridschicht **12a** an der inneren vertikalen Wandfläche des leitenden Ringes **13a** vollständig erhalten bleibt.
Danach wird eine 140 nm dicke Siliciumdioxidschicht als zweite Isolationsmantelschicht **12b** mit einem LPCVD-Verfahren abgeschieden und anschließend durch einen anisotropen RIE-Prozeß auf allen horizontalen Flächen wieder entfernt. Durch Fortsetzung des RIE-Prozesses wird nachfolgend das im Zentrum des leitenden Ringes **13a** verbliebene Drainkontaktfenster bis auf die Substratoberfläche geöffnet. Der leitende Ring **13a** ist somit an seiner oberen Deckfläche und seiner inneren vertikalen Wandfläche durch einen selbstjustierten Isolationsmantel **12c**, der aus den beiden maskenfrei strukturierten Isolationsmantelschichten **12a, 12b** gebildet wird, bedeckt.
Danach wird eine n⁺-leitende Polysiliciumschicht mit einer Dicke größer als der Radius des durch den leitenden Ring **13a** und den Isolationsmantel **12c** verengten Drainkontaktfensters als unterste leitende Schicht **9** der STC-Speicherelektrode 8a abgeschieden.
Diese Schicht **9** füllt das im Zentrum des leitenden Ringes **13a** und seines Isolationsmantels **12c** verbliebene Drainkontaktfenster in Form eines zum Isolationsmantel **12c** und zum leitenden Ring **13a** selbstjustierten leitenden Stempels **9a**, der den Kontakt zum Drain **6** des MOS-Auswahltransistors **3** herstellt und in seinem oberen Abschnitt in die STC-Speicherelektrode **8a** übergeht, vollständig aus.
Danach wird der STC-COB-Speicherchip, beginnend mit der Komplettierung des 3D-STC-Komplexes **8**, fertiggestellt.

### Aufstellung der verwendeten Bezugszeichen

- 1.: einkristallines Halbleitersubstrat
- 2.: Feldisolation
- 3.: Wortleitung bzw. MOS-Auswahltransistor
- 4.: Wortleitungsisolation
- 5.: Sourcegebiet des MOSFET
- 6.: Draingebiet des MOSFET
- 7.: Bitleitung
- 8.: STC-Speicherkapazität (Speicherkapazitätskomplex)
- 8a.: STC-Speicherelektrode (Grundelektrode)
- 8b.: STC-Zellplatte (Deckelektrode)
- 9.: unterste leitende Schicht der STC-Speicherelektrode
- 9a.: isolierter, leitender Stempel
- 10.: zwischen Wort- und Bitleitung liegende untere Isolationsschicht
- 11.: zwischen Bitleitung und STC-Speicherelektrode liegende untere Isolationsschicht
- 12.: Isolationsmantelschicht
- 12a.: erste Isolationsmantelschicht
- 12b.: zweite Isolationsmantelschicht
- 12c.: Isolationsmantel
- 13.: leitende Schicht
- 13a.: leitender Ring

## Patentansprüche

1. Stacked-capacitor-Ein-Transistor-Speicherzelle für höchstintegrierte dynamische Halbleiterspeicher, bestehend aus Feldisolationsgebiet und aktivem Gebiet eines einkristallinen Halbleitersubstrates, in dem ein MOS-Feldeffekttransistor mit einer Wortleitung und einem Source- und einem Draingebiet integriert ist, einer mit dem Sourcegebiet kontaktierten, über der Wortleitungsebene isoliert angeordneten Bitleitung sowie einem über der Bitleitung angeordneten, das Gebiet der Speicherzelle weitgehend bedeckenden Stapelkondensatorkomplex, welcher mit seiner Speicherelektrode an das Draingebiet angeschlossen ist und dessen Deckelektrode als Zellplatte aller Speicherzellen eines Speichermatrixblocks ausgebildet ist, **dadurch gekennzeichnet,**
- **daß** ein isolierter, leitender Stempel **(9a)**, der das Draingebiet **(6)** im Drainkontaktfenster kontaktiert, die zwischen Wort- und Bitleitungsebene liegende untere Isolationsschicht **(10)**, die Bitleitung **(7)** und die darüberliegende obere Isolationsschicht **(11)** durchstößt und in die Unterseite der STC-Speicherelektrode **(8a)** übergeht,
- wobei der Stempel **(9a)** von einem Isolationsmantel **(12c)** bedeckt ist, der die laterale Isolation zur Bitleitung **(7)** sicherstellt,
- der Isolationsmantel **(12c)** mit konstanter Dicke selbstjustierend zentriert zum Stempel **(9a)** angeordnet ist,
- die durch den Stempel **(9a)** und dessen Isolationsmantel **(12c)** angeschnittene Bitleitung **(7)** einseitig oder beidseitig um den Stempel **(9a)** herumgeführt oder die Bitleitung **(7)** durch den Stempel **(9a)** vollständig durchtrennt ist wobei an der Bitleitung **(7)** in jedem Fall ein leitfähiger Ring **(13a)** zur Sicherstellung des elektrisch erforderlichen Mindestquerschnitts der Bitleitung **(7)** im unmittelbaren Bereich des Stempels **(9a)** angeordnet ist und
die Höhe des leitfähigen Ringes **(13a)** größer ist als die Höhe der Bitleitung **(7)** außerhalb des Bereichs des Stempels **(9a)**.

2. Verfahren zur Herstellung einer Stacked-capacitor-Ein-Transistor-Speicherzelle gemäß Anspruch 1, **dadurch gekennzeichnet,**
- **daß** nach Herstellung der Wortleitungen **(3)** und der Source-**(5)** und Draingebiete **(6)** eine untere Isolationsschicht **(10)** ausgebildet wird,
- **daß** danach das Sourcekontaktfenster strukturiert wird,
- **daß** anschließend die Bitleitung **(7)** ausgebildet wird, wobei zugleich der Sourcekontakt hergestellt wird,
- **daß** im Anschluß daran eine die Bitleitung **(7)** bedeckende obere Isolationsschicht **(11)** ausgebildet wird,
- **daß** danach durch einen anisotropen Ätzprozeß über eine Lackmaske ein Drainkontaktfensters im Drainbereich durch die obere Isolationsschicht **(11)**, durch die Bitleitung **(7)** und durch die untere Isolationsschicht **(10)** geätzt wird, die Bitleitung **(7)** dabei einseitig angeschnitten oder beidseitig um den Stempel **(9a)** herumgeführt oder vollständig durchtrennt wird,
- der Ätzprozeß vor Erreichen der Drainoberfläche des Substrates **(1)** gestoppt wird, so daß die innerhalb des Drainkontaktfensters liegenden Teile der Feld-**(2)** und Wortleitungsisolation **(4)** nicht beschädigt werden,
- die Bitleitung **(7)** durch einen leitfähigen Ring **(13a)** verstärkt wird,
- **daß** anschließend eine Isolationsmantelschicht **(12)** isotrop abgeschieden wird, wobei deren Dicke deutlich kleiner als die halbe Drainkontaktfensterbreite ist,
- **daß** im Anschluß daran mittels eines anisotropen RIE-Prozesses das durch die Isolationsmantelschicht **(12)** verengte Drainkontaktfenster bis auf die Drainoberfläche des Substrates **(1)** vertieft wird, wodurch eine rundum isolierende, selbstjustierende Bedeckung der Drainkontaktfensterflanken und der freiliegenden Flanken der Bitleitung **(7)** in Form eines Isolationsmantels **(12c)** erzeugt wird und daß anschließend der STC-Komplex **(8)**, beginnend mit der Abscheidung der untersten leitenden Schicht **(9)** der STC-Speicherelektrode **(8a)** ausgebildet wird, wobei die Dicke dieser untersten leitenden Schicht **(9)** der STC-Speicherelektrode größer ist als die durch den Isolationsmantel **(12c)** verminderte halbe Breite des Drainkontaktfensters, so daß dieses vollständig mit einem leitenden Stempel **(9a)** ausgefüllt wird, der in seinem oberen Abschnitt in die STC-Speicherelektrode **(8a)** übergeht.

3. Verfahren nach Anspruch 2, **dadurch gekennzeichnet, daß** die im Drainkontaktfensterbereich im Querschnitt geschwächte Bitleitung **(7)** vor der Herstellung des Isolationsmantels (12c) durch einen leitfähigen Ring **(13a)** verstärkt wird,
- indem bei dem anisotropen RIE-Prozeß zur Ätzung des Drainkontaktfensters, der die Bitleitung **(7)** im Drainbereich in ihrer Breite völlig oder teilweise durchtrennt, die untere Isolationsschicht **(10)** zunächst nur teilweise angeätzt wird,
- daß danach eine leitende Schicht **(13)** isotrop abgeschieden wird, wobei die Dicke dieser Schicht deutlich kleiner als die halbe Drainkontaktfensterbreite ist,
- daß im Anschluß daran ein anisotroper RIE-Prozeß durchgeführt wird, der die leitende Schicht **(13)** auf der oberen Isolationsschicht **(11)** und auf dem Boden des Drainkontaktfensters entfernt, an den Flanken des Drainkontaktfensters jedoch einen leitfähigen Ring **(13a)** stehen läßt, der die bei der Drainkontaktfensterstrukturierung an den Drainkontaktfensterflanken entstehenden freien Bitleitungsflanken mit seinem äußeren Umfang kontaktiert,
- daß nachfolgend eine erste Isolationsmantelschicht **(12a)** mit einer Dicke, die deutlich kleiner ist als die durch den leitenden Ring **(13a)** verringerte halbe Breite des Drainkontaktfensters, isotrop abgeschieden wird bzw. das Bitleitungsringmaterial zur Ausbildung der Isolationsschicht **(12a)** oxidiert oder nitriert wird, wobei dieser Schichtausbildung eine weitere Schichtabscheidung zur Ausbildung der kompletten ersten Isolationsschicht **(12a)** folgen kann,
- daß anschließend die erste Isolationsmantelschicht **(12a)** mit einem anisotropen RIE-Prozeß auf allen horizontalen Flächen abgeätzt wird, während sie an der inneren senkrechten Wandfläche des leitenden Rings **(13a)** verbleibt,
- daß danach der leitende Ring **(13a)** selektiv zur umgebenden Isolation bis auf ein Niveau oberhalb der Bitleitungsoberfläche abgeätzt wird, wobei die erste Isolationsmantelschicht **(12a)**, welche die innere Wandfläche des Rings **(13a)** bedeckt, als Bestandteil des Isolationsmantels **(12c)** vollständig erhalten bleibt,
- daß anschließend eine zweite Isolationsmantelschicht **(12b)** mit einer Schichtdicke größer als die halbe Wandstärke des Rings **(13a)** isotrop abgeschieden wird,
- daß im Anschluß daran das Drainkontaktfenster mit einem RIE-Prozeß bis auf die Substratoberfläche maskenlos und anisotrop strukturiert wird, wodurch zugleich der Isolationsmantel **(12c)** komplettiert wird und
- daß danach der STC-Komplex **(8)** beginnend mit der Abscheidung der untersten Schicht **(9)** der STC-Speicherelektrode **(8a)** ausgebildet wird, wobei deren Dicke größer ist als die nach Ausbildung des Isolationsmantels **(12c)** verbleibende halbe Breite des Drainkontaktfensters, so daß dieses vollständig mit einem leitenden Stempel **(9a)** ausgefüllt wird, der in seinem oberen Abschnitt in die STC-Speicherelektrode **(2)** übergeht.

## Claims

1. Stacked capacitor single-transistor memory cell for VLSI dynamic semiconductor memories, comprising field insulation region and active region of a monocrystalline semiconductor substrate, in which a MOS field effect transistor is integrated with a word line and a source and drain region, a bit line connected to the source region and positioned above but insulated from the word-line plane, plus a stacked capacitor structure located above the bit line and covering a large area of the memory cell, which is connected to the drain region by its storage electrode and whose top electrode is designed as cell plate for all memory cells of a memory matrix block, **characterised**
- **in that** an insulated, conducting post **(9a)**, which is connected to the drain region **(6)** in the drain contact window, and which penetrates the insulating layer **(10)** lying between the word- and bit-line planes, the bit line **(7)** and the upper insulating layer **(11)** lying above it, and passes into the underside of the STC storage electrode **(8a)**,
- where the post **(9a)** is covered by an insulating sheath **(12c)** that provides the lateral isolation from the bit line **(7)**,
- the insulating sheath **(12c)** is formed with constant thickness and self-aligned with the centre of the post **(9a)**,
- the bit line **(7)**, cut into by the post **(9a)** and its insulating sheath **(12c)**, runs around the post **(9a)** on one side or two sides, or the bit line **(7)** is completely cut through by the post **(9a)**, where in each case a conducting ring **(13a)** is arranged on the bit line 7 in the immediate vicinity of the post **(9a)** in order to guarantee the electrically stipulated minimum cross-section of the bit line **(7)** and the height of the conducting ring **(13a)** is greater than the height of the bit line **(7)** outside the area of the post **(9a)**.

2. Method for the fabrication of a stacked capacitor single-transistor memory cell according to Claim 1, **characterised**
- **in that** after fabrication of the word lines **(3)** and the source regions **(5)** and drain regions **(6)**, a lower insulating layer **(10)** is formed,
- **in that** the source contact window is then created,
- **in that** subsequently the bit line **(7)** is formed, making the source contact at the same time,
- **in that** after this an upper insulating layer **(11)** is formed that covers the bit line **(7)**,
- **in that** then a drain contact window is etched in the drain region through the upper insulating layer **(11)**, through the bit line **(7)** and through the lower insulating layer **(10)** by an anisotropic etching process using a resist mask, the bit line **(7)** being cut into on one side in the process, or passing the post **(9a)** on both sides or being completely cut through,
- the etching process is stopped before reaching the drain surface of the substrate **(1)** to prevent damage to the sections of the field-line insulation **(2)** and word-line insulation **(4)** lying within the drain contact window,
- the bit line **(7)** is reinforced by a conducting ring **(13a)**
- **in that** then an insulating sheath layer **(12)** is formed by anisotropic deposition, where the thickness of this layer is distinctly smaller than half the width of the drain contact window,
- **in that** subsequently the drain contact window narrowed by the insulating sheath layer **(12)** is deepened down to the drain surface of the substrate **(1)** by means of an anisotropic RIE process, by which means an insulating, self-aligning covering in the form of an insulating sheath **(12c)** is created all around the sides of the drain contact window including the exposed edges of the bit line **(7)**, and in that after this the STC structure **(8)** is formed, beginning with the deposition of the lowest conducting layer **(9)** of the STC storage electrode **(8a)**, where this lowest conducting layer **(9)** of the STC storage electrode is thicker than half the drain contact window width that has been reduced by the insulating sheath **(12c)**, so that this window is completely filled with a conducting post **(9a)** whose top section passes into the STC storage electrode **(8a)**.

3. Method according to Claim 2, **characterised in that** the bit line **(7)** whose cross-section has been reduced in the region of the drain contact window is reinforced by a conducting ring **(13a)** before fabrication of the insulating sheath **(12c)**,
- by initially only partially etching into the lower insulating layer **(10)** during the anisotropic RIE process used to etch the drain contact window that cuts through the full or partial width of the bit line **(7)** in the drain region,
- **in that** then isotropic deposition is used to form a conducting layer **(13)** whose thickness is distinctly smaller than half the width of the drain contact window,
- **in that** then an anisotropic RIE process is performed that removes the conducting layer **(13)** from the top insulating layer **(11)** and the base of the drain contact window while leaving around the sides of the drain contact window a conducting ring **(13a)** that makes contact around its outer perimeter with the edges of the bit line exposed around the sides of the drain contact window during formation of the drain contact window,
- **in that** then isotropic deposition is used to create a first insulating sheath layer **(12a)** whose thickness is distinctly smaller than half the width of the drain contact window reduced by the conducting ring **(13a)**, or the insulating layer **(12a)** is created by oxidising or nitrifying the bit-line ring material, where a further layer deposition may follow this layer formation in order to create the complete first insulating layer **(12a)**.
- **in that** then the first insulating sheath layer **(12a)** is etched from all horizontal surfaces with an anisotropic RIE process, while it remains on the inner vertical wall surface of the conducting ring **(13a)**,
- **in that** after this the conducting ring **(13a)** is etched selectively from the surrounding insulation down to a level above the bit-line surface, whereby the first insulating sheath layer **(12a)** covering the inner wall surface of the ring **(13a)** remains completely intact as part of the insulating sheath **(12c)**,
- **in that** then a second insulating sheath layer **(12b)** which is thicker than half the wall thickness of the ring **(13a)** is formed by isotropic deposition,
- **in that** after this the drain contact window is etched right down to the substrate surface by anisotropic, mask-free etching in an RIE process, this step also completing the insulating sheath **(12c)**,
- **in that** then the STC structure **(8)** is formed, beginning with deposition of the lowest layer **(9)** of the STC storage electrode **(8a)**, where this lowest layer is thicker than half the drain contact window width that remains after formation of the insulating sheath **(12c)**, so that this window is completely filled with a conducting post **(9a)** whose top section passes into the STC storage electrode **(2)**.

## Revendications

1. Cellule de mémoire à un transistor à condensateur empilé pour des mémoires semi-conductrices dynamiques à forte intégration, composée d'une zone d'isolation de champ et d'une zone active d'un substrat semi-conducteur monocristallin dans lequel est intégré un transistor à effet de champ MOS avec une ligne de mots et une zone de source et une zone de drain, d'une ligne de bits en contact avec la zone de source et isolée par le plan de la ligne de mots, ainsi que d'un complexe condensateur empilé recouvrant très largement la ligne de bits et la zone de la cellule de mémoire, ce complexe étant relié par son électrode de mémoire à la zone de drain et son électrode de recouvrement étant réalisée comme plaque de cellule pour toutes les cellules de mémoire d'un bloc de la matrice de mémoire,
**caractérisé en ce que**
- un tampon conducteur isolé (9a) en contact avec la zone de drain (6) dans la fenêtre de contact de drain, traverse la couche d'isolation inférieure située (10) entre les plans de la ligne de mots et de la ligne de bits, la ligne de bits (7) et la couche d'isolation (11) supérieures, placée au-dessus, et rejoint le côté inférieur de l'électrode de mémoire STC (8a),
- le tampon (9a) est couvert par une enveloppe d'isolation (12c) qui garantit l'isolation latérale de la ligne de bits (7),
- l'enveloppe d'isolation (12c) est centrée de manière auto ajustée avec une épaisseur constante par rapport au tampon (9a),
- la ligne de bits (7) coupée partiellement par le tampon (9a) et l'enveloppe d'isolation (12c), tourne d'un côté ou des deux côtés autour du tampon (9a), ou la ligne de bits (7) est complètement séparée par le tampon (9a), la ligne de bits (7) comportant dans tous les cas un anneau conducteur (13a) pour assurer la section minimale nécessaire électriquement de la ligne de bits (7) dans la zone directe du tampon (9a), et
- la hauteur de l'anneau conducteur (13a) est supérieure à la hauteur de la ligne de bits (7) en dehors de la zone du tampon (9a).

2. Procédé de fabrication d'une cellule de mémoire à un transistor et condensateur empilé selon la revendication 1,
**caractérisé en ce qu'**
- on réalise une couche d'isolation inférieure (10) après réalisation des lignes de mots (3) et des zones de source (5) et de drain (6),
- puis on structure la fenêtre de contact de source,
- ensuite on réalise la ligne de bits (7) et en même temps le contact de source,
- ensuite on forme la couche d'isolation supérieure (11) qui couvre la ligne de bits (7),
- ensuite, par un procédé d'attaque anisotrope sur un masque de vernis on décape une fenêtre de contact de drain dans la zone de drain à travers la couche d'isolation supérieure (11), à travers la ligne de bits (7) et à travers la couche d'isolation inférieure (10), on découpe d'un côté la ligne de bits (7) ou on la conduit des deux côtés autour du tampon (9a) ou on la sépare complètement,
- on arrête le procédé de décapage avant d'atteindre la surface supérieure du drain du substrat (1) pour que les parties du champ (2) et de l'isolation de la ligne de mots (4) qui se situent dans la fenêtre de contact de drain ne soient pas endommagées,
- on renforce la ligne de bits (7) par un anneau conducteur (13a),
- ensuite on dépose de manière isotrope une couche d'enveloppe d'isolation (12) dont l'épaisseur est significativement inférieure à la moitié de la largeur de la fenêtre de contact de drain,
- ensuite à l'aide d'un procédé RIE anisotrope on approfondit la fenêtre de contact de drain rétrécie par la couche (12) de l'enveloppe d'isolation jusqu'à la surface de drain du substrat (1), et ainsi on réalise de manière périphérique un recouvrement isolant auto-ajustant des flancs de la fenêtre de contact du drain et des flancs dégagés de la ligne de bits (7) sous la forme d'une enveloppe d'isolation (12c) et
- ensuite on réalise le complexe STC (8) en commençant par le dépôt de la couche conductrice la plus inférieure (9) de l'électrode de mémoire STC (8a),
L'épaisseur de cette couche inférieure conductrice (9) de l'électrode de mémoire STC étant supérieure à la demi largeur de la fenêtre de contact de drain réduite par l'enveloppe d'isolation (12c), pour que celle-ci soit remplie complètement par un tampon conducteur (9a) qui rejoint par son segment supérieur l'électrode de mémoire STC (8a).

3. Procédé de fabrication d'une cellule de mémoire à un transistor et condensateur empilé selon la revendication 2,
**caractérisé en ce qu'**
- on renforce la ligne de bits (7) affaiblie en section dans la zone de la fenêtre de contact de drain avant de réaliser l'enveloppe d'isolation (12c) à l'aide d'un anneau conducteur (13a),
- pour le procédé RIE anisotrope, pour le décapage de la fenêtre de contact de drain, on sépare tout d'abord totalement ou partiellement la ligne de bits (7) dans la zone de drain, dans sa largeur, et on effectue tout d'abord seulement partiellement le décapage de la couche d'isolation inférieure (10),
- puis on dépose de manière isotrope une couche conductrice (13), l'épaisseur de cette couche étant significativement inférieure à la moitié de la largeur de la fenêtre de contact de drain,
- ensuite on exécute un procédé RIE anisotrope qui enlève la couche conductrice (13) de la couche d'isolation supérieure (11) et du fond de la fenêtre de contact de drain en laissant toutefois sur les flancs de la fenêtre de contact de drain, un anneau conducteur (13a) qui est en contact par sa périphérie extérieure avec les flancs libres de la ligne de bits, formée par la mise en structure de la fenêtre de contact de drain au niveau des flancs de cette fenêtre de contact de drain,
- ensuite on dépose une première couche isotrope d'enveloppe d'isolation (12a) d'une épaisseur significativement inférieure à la moitié de la largeur de la fenêtre de contact de drain, diminuée par l'anneau conducteur (13a), ou on oxyde ou on nitrure la matière de l'anneau de la ligne de bits pour former la couche d'isolation (12a), cette formation de couche pouvant être suivie par un autre dépôt d'une couche pour réaliser l'ensemble de la première couche d'isolation (12a),
- ensuite on enlève par décapage la première couche d'enveloppe d'isolation (12a) par un procédé RIE anisotrope sur toutes les surfaces horizontales, tout en laissant cette couche sur les surfaces de paroi de l'anneau conducteur (13a), intérieur, vertical,
- ensuite on enlève par décapage l'anneau conducteur (13a), sélectivement par rapport à l'isolation environnante jusqu'à un niveau au-dessus de la surface de la ligne de bits, la première couche de l'enveloppe d'isolation (12a) qui couvre la surface de paroi intérieure de l'anneau (13a) restant conservée totalement, comme partie de l'enveloppe d'isolation (12c),
- ensuite on dépose de manière isotrope une seconde couche d'enveloppe d'isolation (12b) avec une épaisseur de couche supérieure à la moitié de l'épaisseur de paroi de l'anneau (13a),
- ensuite on réalise la structure de la fenêtre de contact de drain par un procédé RIE anisotrope jusqu'à la surface du substrat, sans utiliser de masque, et on complète en même temps l'enveloppe d'isolation (12c) et
- ensuite on réalise le complexe STC (8) en commençant par le dépôt de la couche la plus inférieure (9) de l'électrode de mémoire STC (8 a), son épaisseur étant supérieure à la demi largeur de la fenêtre de contact de drain qui subsiste après la réalisation de l'enveloppe d'isolation (12c), pour que cette fenêtre soit remplie complètement avec un tampon conducteur (9a) dont le segment supérieur rejoint l'électrode de mémoire STC (2).
